# EUROPEAN PATENT APPLICATION

(11) **EP 2 392 697 A1**
(43) Date of publication of application: **07.12.2011**
(21) Application number: 10164897.0
(22) Date of filing: 03.06.2010
(51) Int. Cl.: C30B 11/12, C30B 29/02, C30B 29/60

(54) **Method and system for growing nano-scale materials**

(71) Applicant: The Provost, Fellows and Scholars of the College of the Holy and Undivided Trinity of Queen Elizabeth near Dublin, Dublin 2 (IE)
(72) Inventor: Jung Jung, Soon, D2, Dublin 2 (IE); Boland, John, D 2, Dublin (IE)
(74) Representative: Lucey, Michael

(57) **Abstract**

The present invention provides a method of producing well defined crystalline nano-wires without complicated multistep manipulation at relatively low temperature. Facile formation of NW materials, particularly metals with a controlled diameter, length and placement. In one embodiment the invention provides a method of growing nano-wires comprising the steps of depositing a first layer of material and a second layer of material on a substrate; annealing said layers at a temperature to allow formation of a composition and subsequently a liquid droplet, at an interface between the first and second layers; and growing nano-wires from said liquid droplet in said interface.

## Description

### Field of the Invention

The invention relates to a method and system for growing materials. In particular the invention relates to a method and system for growing nanoscale nanowire materials.

### Background to the Invention

Mixing two or more materials of different surface energies enables for the growth of nanoscale materials. For example, Silicon (Si) nanowires are grown by feeding silane gas to a nanoscale metal particle for example gold (Au), into which the Si dissolves to forms an Au-Si eutectic mixture. Continuous dissolution of Si into the eutectic mixture results in supersaturation and ultimately the expulsion of Si in the form of a nanowire.

Similarly, carbon nanotubes can be formed by supersaturating a metallic nanoparticle (typically Fe or Ni) with carbon from a hydrocarbon feed-gas. In all these cases nanowires of the non-metallic component (Si or C) are formed and the distribution and size of the nanowires is determined by the placement and diameters of the original metal particles. The limited control on the placement, diameters and lengths of the nanowires are the single biggest problem to their use in device and related applications. Metal nanowires are much more difficult to synthesise and are particularly important for interconnect applications.

Attempts at patterning metal islands on substrates, with limited diffusion, has not proved very successful. Many standard approaches have been extensively developed to produce AuNWs with desired shapes on the basis of particle assembly, surfactant mediation, template assistance or physical deposition.

US Patent publication number US2008138965, Liu et al discloses how an amorphous Si (silicon)/Au (gold) eutectic wafer bonding structure can be fabricated. However, this process does not produce nanowire efficiently and cost effectively in a controlled manner.

There is therefore a need to provide a method and system to produce nano-wires or nano-materials with controlled diameters and lengths that overcome the above mentioned problems.

### Summary of the Invention

According to the present invention there is provided, as set out in the appended claims, method of growing nano-wires comprising the steps of:
depositing a first layer of material and a second layer of material on a substrate;
annealing said layers above a temperature to allow formation of a composition and subsequently a liquid droplet, at an interface between the first and second layers;
growing nano-wires from said liquid droplet in said interface.

The present invention provides a method of producing well defined crystalline metallic nanowires, such as gold and copper nanowires, without complicated multistep manipulation at relatively low temperature. Facile formation of NW materials, particularly metals with a controlled diameter, length and placement. Other semi conductor wires can be grown, according to the method, such as Ge or Si by choosing the right other material. The method allow for the simple production of pure single crystal metal nanowires that are robust and mechanically strong. An important advantage of the invention is that no gases are required for the process to make the wires according to the invention. While the melting of the layers begin at the interface the droplet appears on the surface and the wires typically grow perpendicular to the original interface.

In one embodiment said annealing step further comprises the step of a de-wetting control step to allow formation of said interface and said liquid droplet. The de-wetting step facilitates delivery of the material to the interface (a target area). The invention uses a process to drive the materials from the surrounding surface into the droplet. De-wetting essentially provides for the rupture of a thin liquid film on the substrate (either a liquid itself, or a solid) and allows for the formation of droplets. By annealing over a period of time the droplets can increase in size that facilitates growth of the nano-wires produced. By controlling the de-wetting allows for delivery of material from the first layer to the droplet to produce the nano-wires. The droplet comprises Ge enriched surface and an Au rich core as more Au accumulates it drives the formation of an Au wire. The top layer is Ge and the bottom layer is Au, but the order in which they are deposited are not important, the important point is that the layers get mixed up as the surface layers agglomerate and melt. The process is explained further below in more detail.

In one embodiment the method comprises the further step of controlling the position of said liquid droplet and the interface between the first and second layers.

In one embodiment the method comprises the step of patterned said second layer to facilitate said de-wetting process and spatial positioning of said liquid droplet for growing said nano-wire materials.

In one embodiment said nano-wire materials are grown in a substantially vertical direction to said substrate.

In one embodiment said first layer comprises gold (Au) or copper (Cu).

In one embodiment said second layer comprises germanium (Ge).

In one embodiment there is provided the step of providing a negative patterned germanium overlay layer comprising a plurality of openings, each opening provides the interface position to grow at least one nano-material wire, in response to said annealing.

In one embodiment there is provided the patterning a plurality of gold dots on top of said layer of germanium.

In one embodiment said plurality of gold dots co-operate with said plurality of openings to facilitate forming of a plurality of interfaces. In one embodiment the interfaces are dimensioned to create micro-fluidic-like channels to position NWs.

In one embodiment the substrate comprises silicon with a silicon dioxide surface layer. The surface energy of the substrate must be lower than the other two layers of material.

In one embodiment said step of annealing opens diffusion pathways between said second layer and said first layer to form said interface.

In one embodiment the annealing step further comprises the step of increasing the size of the liquid droplet by annealing over a pre-set period of time. The time required depends on ambient conditions, for example using the process in a vacuum produces nano-wires with smaller diameters. By controlling the ambient condition a balance can be obtained between the obtaining large droplets and larger number of smaller diameter wires. When there is a gas flow, i.e. not vacuum conditions, the gas flow helps to evaporate the smallest droplets. Those that remain tend to become attached to each other or large droplets making larger droplets.

In one embodiment the liquid droplet comprises a ball shaped droplet.

In one embodiment said annealing step operates at a temperature in excess of 400 degrees Celsius. The temperature required should be sufficient to allow intermixing of the first and second layers.

In one embodiment said composition comprises a eutectic composition.

In one embodiment the method comprises the further step of controlling the position of said liquid droplet and the interface between the gold and germanium layers.

In one embodiment the step of controlling comprises providing a negative patterned germanium overlay layer comprising a plurality of openings, each opening provides the interface position to grow at least one metallic wire, in response to said annealing.

In one embodiment the step of controlling further provides patterning a plurality of gold dots on top of said layer of germanium.

In one embodiment the plurality of gold dots cooperate with said plurality of openings.

In one embodiment there is provided at least three materials of different surface energies wherein the substrate has a lowest first energy, the second layer of material comprises a higher second energy than the first layer and the first layer comprises a surface energy greater that the first or second surface energy.

In one embodiment the method comprises the step of providing a third layer for reducing the temperature and/or accelerate the growth rate of said nano-wires.

In one embodiment the third layer comprises tin material or lead material.

In another embodiment there is provided a method of growing metallic wires comprising the steps of:
depositing a layer of metal and a layer of germanium on a substrate;
annealing said layers and substrate above the eutectic temperature to form a eutectic composition and subsequently a liquid droplet, at an interface between the metal and germanium layers;
growing metallic wires from said liquid droplet in said interface.

In a further embodiment there is provided a system adapted for growing nano- wires comprising:
means for depositing a first layer of material and a second layer of material on a substrate;
means for annealing said layers above a temperature to allow formation of a composition and subsequently a liquid droplet, at an interface between the first and second layers;
means for growing nano-wires from said liquid droplet in said interface.

There is also provided a computer program comprising program instructions for causing a computer program to carry out the above method which may be embodied on a record medium, carrier signal or read-only memory.

### Brief Description of the Drawings

The invention will be more clearly understood from the following description of an embodiment thereof, given by way of example only, with reference to the accompanying drawings, in which:-
Figure 1 illustrates a schematic diagram explaining the diffusion, crystallization and growing process according to the invention;
Figure 2 illustrates the controlling of the growth of the Au nano wire according to another aspect of the invention;
Figure 3 illustrates a further schematic diagram explaining the diffusion, crystallization and growing process according to the invention;
Figure 4 illustrates TEM images of the nanowires grown furing the annealing step of the invention;
Figure 5 illustrates how a plurality of nanowires can be grown using pre-patterning technique, according to the invention; and
Figure 6 illustrates a high resolution TEM image of Au wire showing the electron diffraction pattern of corresponding area.

### Detailed Description of the Drawings

The present invention allows for the controlled growth of nanowires that does not involve the need for precise placement of nanoparticle nuclei. In simple terms, the growth process involves the formation of a sputter deposited first layer and second layer, for example Gold-Germanium (Au-Ge) bi layers on a substrate, for example silicon. The thickness of each layer can be controlled in the range of 0-10 nm by varying the deposition time. By subsequently heating to above a temperature, results in the formation of solid solution that opens diffusion pathways for Au and Ge atoms. The continuous Au layer provides sufficient Au atoms for transport along the a a-Ge-Au interface and results in the formation of single crystalline Au nanowires that grow out from eutectic droplets on the Si substrate but are not directly contacted to the substrate itself (may not always be the case, e.g. Cu). By patterning the substrate it is possible to control the position of position of droplet formation and the subsequent Au whisker or nanowire growth. The method of the invention allows for the control of positions, diameters and lengths of the Au nanowires.

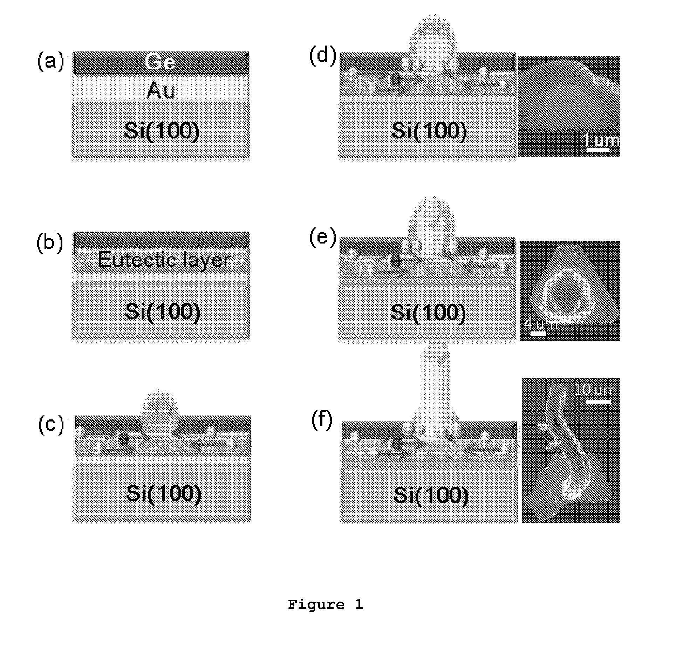

Figure 1 illustrates a schematic diagram explaining the diffusion, crystallization and growing process of Ge/Au bilayer on Si(100) surface according to one embodiment of the present invention.

Different thicknesses of Au films were deposited on Si(100) by varying the sputter-deposition time using a magnetron sputter-coater. Then a Ge film was deposited by thermal evaporation (Fig 1(a)). Finally, the samples were annealed in an atmosphere of hydrogen and argon. Vacuum annealing can also be applied and results in larger numbers of smaller droplets. In one embodiment the annealing temperature can be 400 °C for a period 12 hrs. It is well known that Ge melts at 1213 K but as the Au content is increased, the a-Ge in metal crystallizes at 0.63-0.68Te (K) (Te is the eutectic temperature), much lower than that of an isolated a-Ge film, this phenomenon is called metal-enhanced crystallization. It will be appreciated that lower temperatures can be used, so long as sufficient mixing of the first layer and second layer is achieved to facilitate de-wetting to allow droplet formation.

During annealing of the Ge-Au bilayer on Si(oxidized) two interfacial reactions can occur. One is the reaction between Si substrate and Au layer. This reaction could be excluded from the consideration, since the stable oxide layer of Si surface remains intact at 400°C providing the potential diffusion barrier to eutectic formation between Au layer and Si substrate (at higher temperature the oxide layer reaction can comes into play). The other possible interaction is the amorphorous Ge layer and Au layer. By annealing at 400 °C, above the eutectic temperature, Au and Ge form the eutectic composition at the interface of two layers (Fig. 1(b)) and subsequently a ball shaped liquid droplet forms (Fig. 1(c)). During a preset period of time of annealing, for example 12 hours, the eutectic droplet becomes bigger due to the dissolution of additional Au and Ge by surface diffusion but droplet cannot maintain the equilibrium composition since the diffusion rate of Au is much faster than Ge. The time period can be dramatically reduced by patterning substrate to enhance dewetting in addition to the positioning of the wire growth centre.

In addition, due to the lower surface energy of liquid Ge (0.77 J/m²) compared to liquid Au (1.33 J/m²) at 400 °C, the surface of this liquid eutectic ball becomes Ge enriched, which further increases the Au enrichment within the droplet. Due to its large surface energy Au is driven from the substrate and ball surfaces into the middle of the ball. As a result the composition of the eutectic ball shifts to the Au supersaturated region following the tie line drawn at 400 °C (Fig. 1(d)). The continued Au diffusion from the surrounding surface into the eutectic droplet results in the continued growth of Au crystallite, and ultimately the formation of an Au wire, as shown in Fig. 1(e). Wires grown from the Au 10 nm/Ge 10 nm film on Si(100) surface obtained were approximately 75 um long (Fig. 1(f)).

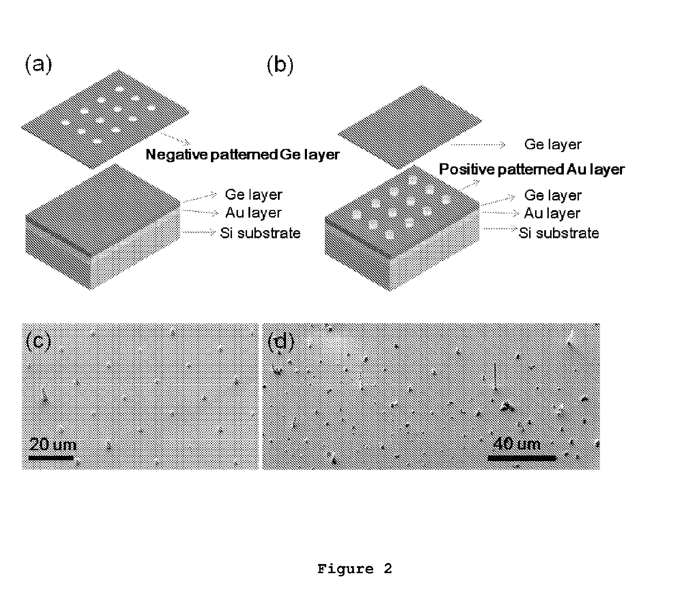

Figure 2 illustrates how the growth of the Au nano-wire can be obtained. Schematic images of process for (a) negative patterned Ge over layer and (b) positively patterned Au dot array are shown. SEM images of Au nano wires grown from (c) negative pattern and (d) positive pattern are shown.

Another important aspect of the invention is the position and diameter control of Au wire produced according to the invention. This can be achieved by patterning the substrate using electron-beam lithography (EBL). Figure 2 (a) shows the schematic of negative patterned substrate; the Au-Ge bilayer with Ge over-layer containing a regular array of holes (square array: 500 nm diameter with a 10 um spacing). After annealing at 400 °C for 12 hours, the single crystal Au wire was grown from pre patterned hole (Fig. 2(c)). While the negative over layer provides diameter and position control, the length of the wires are less than 10 um due to the limited diffusion of Au and Ge. To prevent restriction of the over layer, a positive Au dot can be developed on top of the Au/Ge bilayer as shown in Figure 2(b). However, the wire length is longer than the wire grown from the negative patterned substrate, producing wires in excess of 250 um in length. This patterning technique provides the basis for controlled placement.

An important aspect of the invention is the function of the de-wetting occurring between the two layers. Generally, de-wetting describes the rupture of a thin liquid film on the substrate (either a liquid itself, or a solid) and the formation of droplets. It has been described previously to observe a surface energy driven agglomeration theory based on void nucleation and growth. Basically a film on a surface start of peel back from the substrates and this process starts at pre-existing voids in the film or at the edges of the film where the substrate is exposed. On the other hand, in initially flat, defect-free areas of the film, the nucleation of critical voids simply does not occur due to the high activation barrier. The present invention makes use the effect of de-wetting and agglomeration for a bi-layer film. The entire process is driven by surface energy. The lower surface energy of the substrate makes the film morphologically unstable. The medium surface energy material (Ge in one embodiment) is essentially a catalyst material, while the higher surface energy material is the one that eventually grows into wires (Au described above).

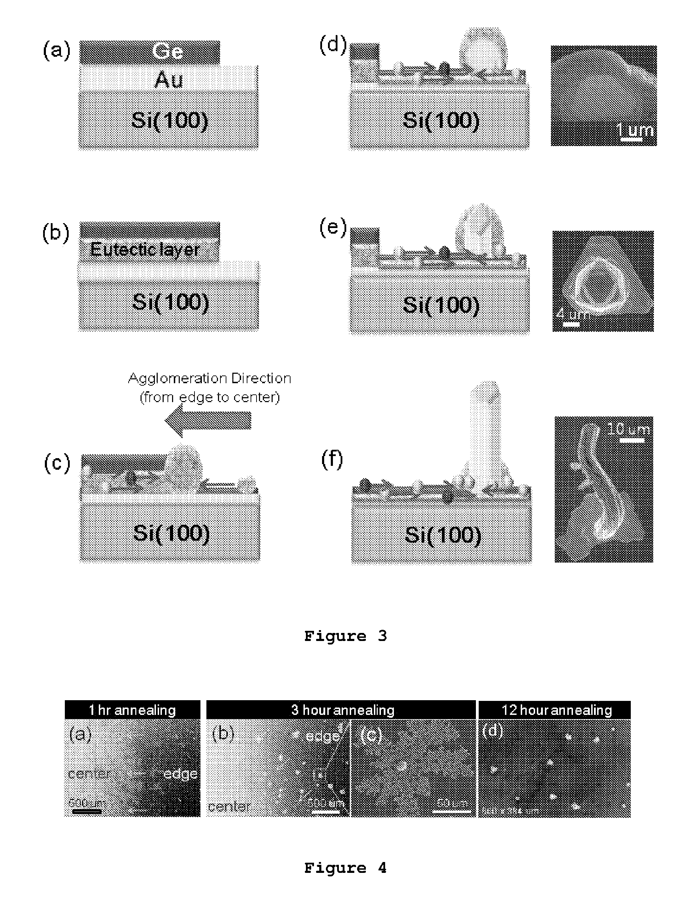

Referring now in detail to Figure 3 and 4, the surface energy of mixed Au-Ge alloy shown contains 24.5 - 29.5 at. % of Ge is expected to be 1.05 - 1.15 J/m².³ Consequentially, the Au-Ge bilayer on top of SiO₂ layer (y = 0.75 J/m²) is morphologically unstable and the alloy tends to de-wet and agglomerate. Figure 4(a) shows an Au 10 nm / Ge 10 nm bilayer after a 1 hour anneal at 400 °C in which agglomeration occurs initially at the film edges, and the yellow arrows in the figure indicate the direction of the agglomeration flow. This observation is consistent with a de-wetting agglomeration model in which voids, defects in the film and the films edges, are nucleation sites due to the presence of exposed regions of the lower energy substrate. Atoms released by the de-wetting process diffuse on the surface and form the dendritic-like structures seen in Fig. 4(a), which are diffusion-limited aggregation (DLA) growth structures. Figure 4(b) shows the agglomerated structure over a larger area after 3 hours annealing at 400 °C. After repeated cycles of release, diffusion and aggregation of atoms, ball shaped structures are formed at the centre of these dendrite aggregates (Fig. 4(c)). After 12 hours annealing the DLA structure has disappeared and ball-like droplets emerged as shown in Fig. 4(d).

The surface of each droplet can comprise Ge enriched material to reduce the droplet surface energy, while the interior is Au-enriched. However, as Au is pumped in to the droplet from the surrounding surface due to the de-wetting process, an Au crystal grows within the interior and ultimately a Au nanowire is expelled.

It was found that if Ar:H₂ flow is not used during growth small levels of Ge segregation at the wire surface are observed. Evidently, the Ar:H₂ flow has the effect of continuously removing this material from the wire surface due to assisted evaporation since a pure Ar flow also produced clean Au wires. Another consequence of removing or limiting the flow gas was a dramatic increase in density of small sized (20 - 500 nm) eutectic droplets which allowed the nucleation and growth of larger numbers of smaller diameter wires.

It will be appreciated that the metallic wires produced according to the present invention has many commercial applications, for example solder fabrications; nanowire interconnects; producing Au nanowires; recrystallisation and purification of Au.

The growth control of the nanowires is controlled by de-wetting. It requires at least three materials of different surface energies. The substrate has the lowest energy, the materials you want to grow has the highest and the other materials is in between.

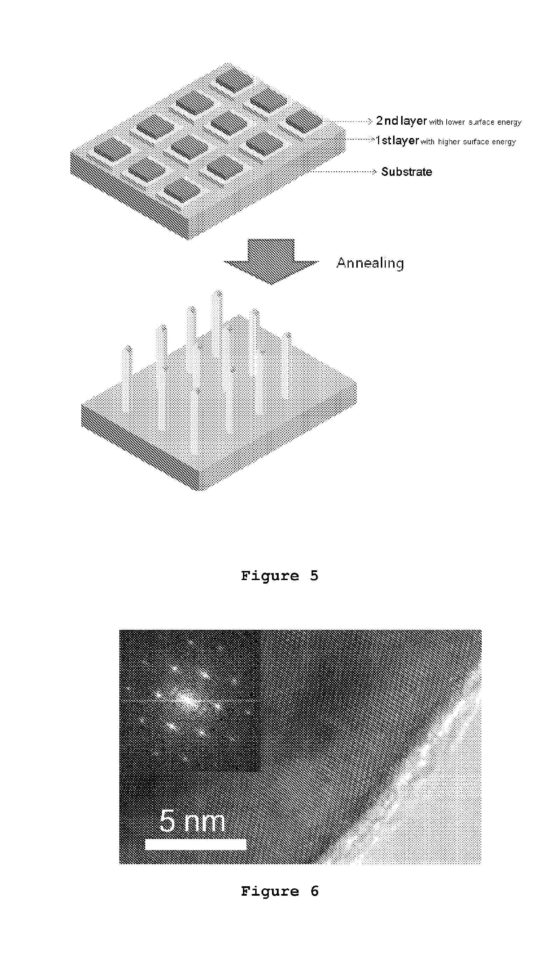

Figure 5 illustrates how an array of nanowires can be grown using pre-patterning technique. The pattern structure in Figure 5 will result in edge driven de-wetting and agglomeration around the perimeter of each patterned square, which will in turn cause the droplet to become positioned in the middle of each square, especially if there is a hole in the top layer. This pre-patterning technique enables wire growth such that all the Au material in each square to be used in the wire formation resulting in wires of equal length. It is envisaged that large numbers of nano-wires can be grown and produced using the pre-patterning technique.

It will be appreciated that additional materials can be added to make ternary and quaternary phase that segregate to yield the desire NW but at much reduced processing temperatures. By adding a small quantity of a third material, for example tin or lead, will drop the growth temperature and increase the growth rate.

A high resolution TEM image and electron deflection pattern of the wire is shown in Figure 6, shows a single crystal f.c.c. structure. The image shows individual atoms and confirms the existence of pure single crystalline nano-wires, which is a highly desirable result.

It will be appreciated that if the amorphous oxide substrate layer is thinned (via chemical reaction - local or otherwise) to expose the crystalline substrate it is possible to have the wires grow along the surface in specific directions due to substrate directed growth.

It will be further appreciated that additional dosing of materials, such as Au or Cu, to continue growth eg larger NWs, without using thicker layers which would require higher growth temperatures.

The embodiments in the invention described with reference to the drawings comprise a computer apparatus and/or processes performed in a computer apparatus. However, the invention also extends to computer programs, particularly computer programs stored on or in a carrier adapted to control the process and effect the process into practice. The program may be in the form of source code, object code, or a code intermediate source and object code, such as in partially compiled form or in any other form suitable for use in the implementation of the method according to the invention. The carrier may comprise a storage medium such as ROM, e.g. CD ROM, or magnetic recording medium, e.g. a floppy disk or hard disk. The carrier may be an electrical or optical signal which may be transmitted via an electrical or an optical cable or by radio or other means.

In the specification the terms "comprise, comprises, comprised and comprising" or any variation thereof and the terms include, includes, included and including" or any variation thereof are considered to be totally interchangeable and they should all be afforded the widest possible interpretation and vice versa.

The invention is not limited to the embodiments hereinbefore described but may be varied in both construction and detail.

## Claims

1. A method of growing nano-wires comprising the steps of:
depositing a first layer of material and a second layer of material on a substrate;
annealing said layers at a temperature to allow formation of a composition and subsequently a liquid droplet, at an interface between the first and second layers; and
growing nano-wires from said liquid droplet in said interface.

2. The method of claim 1 wherein said annealing step further comprises a de-wetting control step to allow formation of said interface and said liquid droplet.

3. The method of claim 1 or 2 comprising the further step of controlling the position of said liquid droplet and the interface between the first and second layers.

4. The method of claim in claims 2 or 3 comprising the step of patterned said second layer to facilitate said de-wetting process and spatial positioning of said liquid droplet for growing said nano-wire materials.

5. The method of any preceding claim wherein said nano-wire materials are grown in a substantially vertical direction to said substrate.

6. The method of any preceding claim wherein said first layer comprises gold (Au) or copper (Cu).

7. The method of any preceding claim wherein said second layer comprises germanium (Ge).

8. The method of claim 7 comprising the step of providing a negative patterned germanium overlay layer comprising a plurality of openings, each opening provides the interface position to grow at least one nano-material wire, in response to said annealing.

9. The method of claim 8 wherein the step of controlling further provides patterning a plurality of gold dots on top of said layer of germanium.

10. The method claim 9 wherein said plurality of gold dots co-operate with said plurality of openings to facilitate forming of a plurality of interfaces.

11. The method of any preceding claim wherein the substrate comprises silicon.

12. The method of any preceding claim wherein said step of annealing opens diffusion pathways between said second layer and said first layer to form said interface.

13. The method of any preceding claim wherein the annealing step further comprises the step of increasing the size of the liquid droplet by annealing over a pre-set period of time.

14. The method of any preceding claim wherein the liquid droplet comprises a ball shaped droplet.

15. The method of any preceding claim wherein said annealing step operates at a temperature in excess of 400 degrees Celsius.
